# DEMANDE DE BREVET EUROPEEN

(11) **EP 0 604 280 A1**
(43) Date de publication de la demande: **29.06.1994**
(21) Numéro de dépôt: 93403071.9
(22) Date de dépôt: 17.12.1993
(51) Int. Cl.: H03H 3/04

(54) **Procédé d'ajustage en fréquence d'un dispositif piézoélectrique et équipement pour la mise en oeuvre du procédé**

(30) Priorité: 22.12.1992 FR 9215475
(71) Demandeur: COMPAGNIE D'ELECTRONIQUE ET DE PIEZO-ELECTRICITE - C.E.P.E., F-95100 Argenteuil (FR)
(72) Inventeur: Michel, Jean-Philippe, F-92402 Courbevoie Cedex (FR); Zafrany, Michael, F-92402 Courbevoie Cedex (FR)
(74) Mandataire: Simonnet, Christine

(57) **Abrégé**

Le procédé selon l'invention est un procédé d'ajustage en fréquence d'un dispositif piézoélectrique (1) comportant au moins une fonction résonante formée de deux électrodes (4,5) métallisées placées en vis-à-vis chacune sur une face différente d'une lame (2) en matériau piézoélectrique.

Il consiste à :
- disposer la lame munie des électrodes métallisées en excès en position d'ajustage à proximité d'une source d'ions,
- à exposer la lame à un flux d'ions produit par la source, le flux d'ions attaquant le métal,
- à mesurer la fréquence de résonance de la fonction résonante pendant que la lame est en position d'ajustage,
- à porter au moins une électrode (4) exposée au flux d'ions à un potentiel de polarisation réglable de manière à contrôler la vitesse d'attaque du métal sur l'électrode (4).

- Application :: ajustage en fréquence de résonateurs piézoélectriques.

## Description

La présente invention concerne un procédé d'ajustage en fréquence d'un dispositif piézoélectrique et un équipement pour la mise en oeuvre du procédé.

Par dispositif piézoélectrique on entend une lame en matériau piézoélectrique comportant au moins une fonction résonante formée de deux électrodes en vis à vis situées chacune sur une face principale différente de la lame. La lame est fixée sur une embase qui comporte des connexions électriques reliées aux électrodes.

Un dispositif piezoélectrique peut regrouper plusieurs fonctions résonantes sur la même lame. Lorsque les électrodes de plusieurs fonctions résonantes sont très proches les unes des autres, les fonctions sont couplées mécaniquement. Les fonctions résonantes couplées peuvent avoir une électrode commune. Les électrodes sont réalisées par une couche de métal déposée sur la lame en matériau piézoélectrique.

La valeur de la fréquence de résonance d'une fonction résonante est déterminée en premier lieu par l'épaisseur de la lame de matériau piézoélectrique mais aussi par l'épaisseur du métal des électrodes. Dans le cas où les fonctions résonantes sont couplées mécaniquement, la valeur du couplage dépend de la proximité des électrodes des deux fonctions résonantes mais aussi de l'épaisseur du métal des électrodes.

Plusieurs procédés sont pratiqués actuellement pour ajuster la fréquence de fonctions résonantes. Ils se répartissent en deux catégories, Les procédés par apport de métal consistent à métalliser, une lame initialement dépourvue de métallisation ou à recharger une lame déjà partiellement métallisée, Les procédés par retrait de métallisation consistent à amincir, au moins une éleclrode déposée au préalable.

Parmi les procédés par apport de métal, on peut citer le dépôt électrolytique d'or sur au moins une électrode déjà déposée. Au cours de ce procédé, l'électrode est connectée électriquement à une source de courant contrôlée dont elle constitue la cathode. La lame en matériau piézoélectrique est plongée dans un bain de sels d'or. L'application du courant provoque le dépôt d'or sur l'électrode. Le contrôle du courant, de la température, de la concentration, du pH, du temps d'immersion permet de réaliser l'ajustage en fréquence. Ce procédé permet d'ajuster en fréquence plusieurs fonctions résonantes. Il suffit de connecter à la source de courant au moins une électrode de chaque fonction résonante. Ce procédé est difficilement automatisable du fait que la mesure de la fréquence de la fonction résonante ne peut se faire pendant que la lame en matériau piézoélectrique est immergée.

On peut aussi citer le dépôt métallique sous vide. La lame en matériau piézoélectrique est introduite dans une enceinte où est maintenu un vide secondaire et où se trouvent deux sources de métallisation face à face. La lame est déjà fixée sur son embase qui comporte des connexions électriques mais les électrodes n'ont pas été déposées.

Des masques sont interposés entre les sources et la lame. Les masques présentent des ouvertures correspondant aux dimensions des électrodes à déposer. Les masques sont sans contact avec les lames à cause des dispositifs de fixation et de connexion.

Des volets mobiles permettent d'occulter à volonté les ouvertures des masques. La fréquence de chaque fonction résonante est mesurée pendant la métallisation qui ne se dépose qu'aux endroits laissés apparents par les ouvertures des masques. Dès que la fréquence d'une fonction résonante a atteint son objectif, les ouvertures des masques correspondant aux électrodes de cette fonction sont occultées par l'interposition des volets. Le principal inconvénient de ce procédé réside dans le fait que le contour des électrodes manque de précision car les masques ne sont pas en contact avec la lame.

Parmi les procédés par retrait, on peut citer l'attaque chimique des électrodes. Dans ce procédé les électrodes sont préalablement déposées sur la lame en matériau piézoélectrique. Au moins une électrode est soumise à l'action d'un agent chimique attaquant le métal de l'électrode. Cette action est appliquée grâce à un tampon imbibé de l'agent chimique. La discrimination des électrodes est obtenue par application sélective du tampon. Ce procédé ne permet pas de mesurer la fréquence des fonctions résonantes pendant l'application du tampon. Ce procédé est limité vers les hautes fréquences. Dans ce cas, les électrodes sont très petites (de l'ordre du centième de millimètre carré) et une discrimination d'une électrode parmi plusieurs n'est pas possible avec le tampon.

La présente invention a pour but de remédier aux inconvénients des procédés connus.

Le procédé selon l'invention permet plus particulièrement d'ajuster en fréquence les dispositifs à plusieurs fonctions résonantes. La présente invention propose un procédé qui permette d'ajuster en fréquence un dispositif piézoélectrique pouvant regrouper un nombre quelconque de fonctions résonantes sur une même lame, qui n'utilise pas de mouvements mécaniques pour assurer la différenciation des fonctions résonantes et qui ne modifie pas le contour des électrodes.

La présente invention propose un procédé d'ajustage en fréquence d'un dispositif piezoélectrique comportant au moins une fonction résonante formée de deux électrodes métallisées, placées en vis à vis chacune sur une face d'une rnême lame en matériau piezoélectrique. Il consiste:
- à disposer la lame en matériau piézoélectrique, munie des électrodes métallisées en excès en position d'ajustage à proximité d'une source d'ions,
- à exposer la lame à un flux d'ions produit par la source, le flux d'ions attaquant le métal,
- à mesurer la fréquence de résonance de la fonction résonante pendant que la lame est en position d'ajustage,
- à porter au moins une électrode exposée au flux d'ions à un potentiel de polarisation réglable de manière à contrôler la vitesse d'attaque du métal sur l'électrode.

Lorsque la lame en matériau piézoelectrique comporte plusieurs fonctions résonantes, on peut régler le potentiel de polarisation appliqué sur une ou plusieurs électrodes exposées au flux d'ions, à une valeur visant à annuler la vitesse d'attaque dès que les fonctions résonantes correspondant à ces électrodes ont atteint un objectif de fréquence déterminé.

Une variante consiste à régler le potentiel de polarisation appliqué sur une ou plusieurs électrodes exposées au flux d'ions à une valeur choisie pour que toutes les fonctions résonantes atteignent un objectif de fréquence déterminé en un même temps d'exposition.

L'invention propose aussi un équipement d'ajustage pour mettre en oeuvre le procédé. Il comporte, dans une enceinte étanche, au moins un canon à ions produisant un faisceau d'ions dirigé selon un axe XX' vers une face de la lame en matériau piézoélectrique, des moyens pour mesurer la fréquence de résonance de la fonction résonante, des moyens pour appliquer le potentiel de polarisation réglable à l'électrode exposée au flux d'ions.

D'autres caractéristiques et avantages de la présente invention apparaîtront à la lecture de la description de modes de réalisation particuliers donnés à titre d'exemples, et illustrée par les figures annexées qui représentent :
- la figure 1a : un équipement d'ajustage selon l'invention ;
- la figure 1b : un dispositif piézoélectrique à ajuster ;
- la figure 2 : une variante d'un équipement d'ajustage selon l'invention ;
- la figure 3 : une variante d'un dispositif piézoélectrique en position d'ajustage.

Le procédé d'ajustage en fréquence selon l'invention est un procédé par retrait de métal. Le retrait de métal est obtenu par bombardement ionique du dispositif à ajuster provoquant une érosion de l'épaisseur de métal sur les électrodes.

Le procédé est particulièrement intéressant pour l'ajustage en fréquence de dispositifs piézoélectriques regroupant sur une même lame plusieurs fonctions résonantes qu'elles soient couplées ou non.

Le dispositif piézoélectrique comporte au moins une fonction résonante formée de deux électrodes métalliques placées en vis à vis, chacune sur une face différente de la lame. Le dispositif piézoélectrique muni de ses électrodes métallisées en excès est exposé à un flux d'ions.

La fréquence de résonance de la fonction résonante est mesurée pendant l'ajustage.

Au moins une électrode de la fonction résonante, exposée au flux d'ions est portée à une tension de polarisation réglable de manière à contrôler la vitesse d'érosion du métal de l'électrode par le flux d'ions.

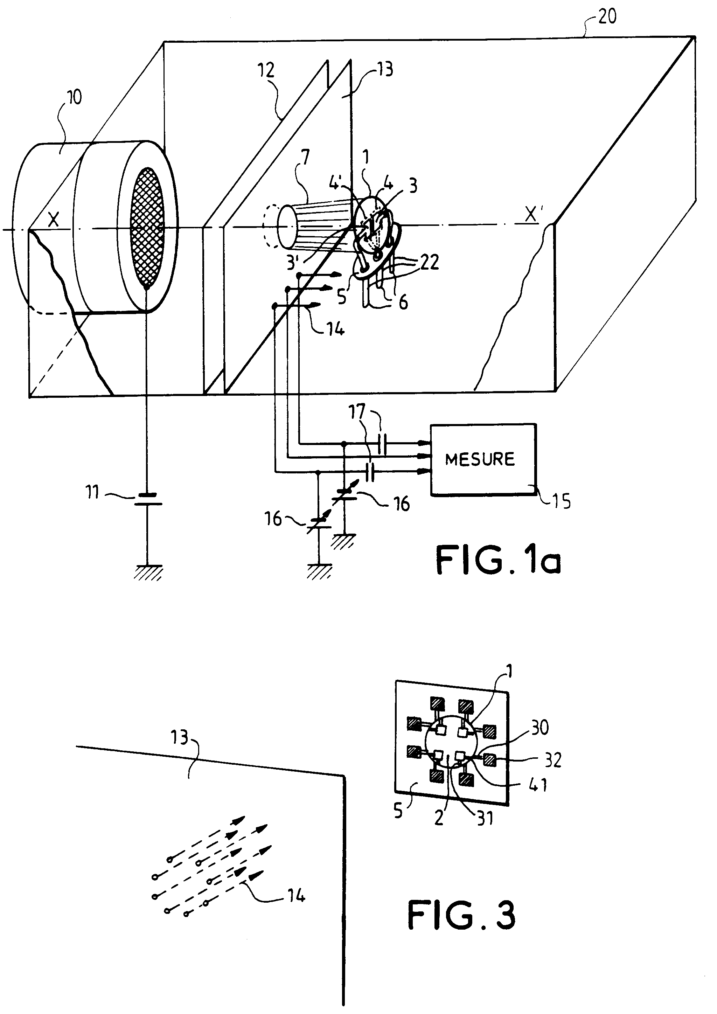

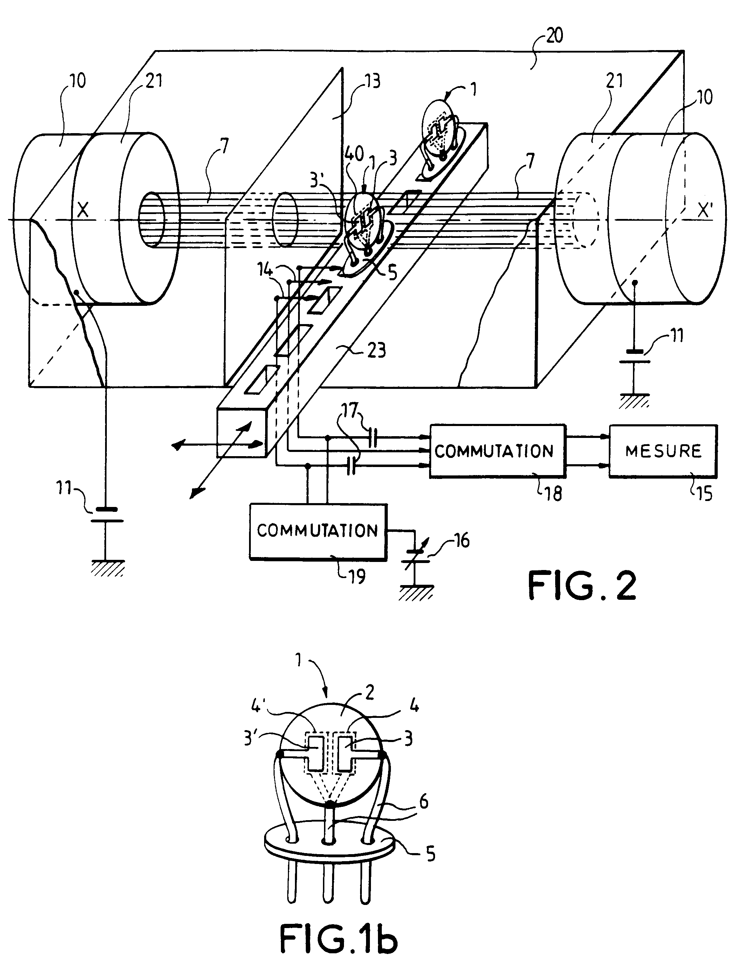

La figure 1a représente un équipement d'ajustage selon l'invention. Un dispositif piézoélectrique à ajuster en fréquence est représenté en détail sur la figure 1b. Il porte la référence 1. Ce dispositif a deux fonctions résonantes découplées. Ce n'est qu'un exemple, il pourrait avoir une seule ou plus de deux fonctions résonantes. Les fonctions résonantes pourraient être couplées mécaniquement.

Le dispositif piézoélectrique comporte une lame 2 en matériau piézoélectrique munie sur une face, de deux électrodes métalliques 3 et 3' (une par fonction résonante) et sur l'autre face, également de deux électrodes métalliques 4 et 4' (une par fonction résonante). La lame 2 est fixée sur une embase 5 grâce à des éléments de fixation 6 en forme de poteaux qui traversent l'embase 5. Les éléments de fixation 6 sont conducteurs et reliés aux électrodes 3, 3', 4, 4'. Ils servent aussi de connexion électrique des électrodes. Il n'y a que trois éléments de fixation 6, deux des électrodes 4, 4' d'une face étant connectées au même élément de fixation 6.

L'équipement d'ajustage en fréquence selon l'invention peut être utilisé avec d'autres types de dispositifs piézoélectriques. Tout type d'embase ou tout type de lame peut être utilisé, ainsi que toute technologie de report, de montage et de connexion électrique. En particulier, les embases pourront être des embases à passage verre-métal, équipées de ressorts métalliques, de fixation connectées par collage, soudure, brasure. Il pourra aussi s'agir d'embases en céramique ou à base de céramique équipées de ressorts métalliques brasés, destinés à la fixation où la connexion est assurée par collage, soudure ou brasure, ou encore d'embases en céramique ou à base de céramique où la fixation et la connexion sont assurées par de la colle.

Le dispositif piézoélectrique 1, placé dans une enceinte étanche 20, est soumis à un flux d'ions 7. Ces ions sont produits par une source telle qu'un canon à ions 10. Sur la figure 1a, il n'y a qu'un seul canon à ions. Le canon à ions 10 émet un faisceau d'ions 7 dirigé selon un axe XX'.

Lorsque l'on veut ajuster un dispositif piézoélectrique à fonctions résonantes couplées mécaniquement, il est préférable d'utiliser deux canons à ions 10 (représentés sur la figure 2) de manière à pouvoir agir aussi sur le couplage.

Une alimentation électrique 11 connectée au canon 10 fournit une tension d'accélération aux ions.

Un diaphragme 12 est prévu entre le canon à ions 10 et le dispositif piézoélectrique de manière à limiter la section du faisceau d'ions 7 à la surface à ajuster, afin d'éviter d'attaquer les éléments de fixation 6, l'embase 5 et les autres éléments environnants décrits plus loin. Le diaphragme 12 est relativement proche du dispositif piézoélectrique 1 et il protège l'entourage des projections métalliques engendrées par le bombardement ionique. L'axe XX' passe aux abords du centre du diaphragme 12.

La lame 2 en matériau piézoélectrique a ses faces sensiblement normales à l'axe XX' de manière à ce que les électrodes 4, 4' soient exposées au flux d'ions.

Des moyens sont prévus pour mesurer la fréquence des fonctions résonantes du dispositif piézoélectrique. Un dispositif de polarisation est aussi prévu pour polariser au moins une des électrodes 4, 4' exposées au flux d'ions.

Sur la figure 1a, on a représenté une tête 13 de mesure. Elle est formée de pointes de test 14 qui viennent en contact avec des zones conductrices 22 reliées électriquement aux électrodes 4, 4', 3, 3'. La tête 13 de mesure comporte trois pointes de test 14 montées élastiquement. Les zones conductrices 22 sont sur les éléments de fixation 6 qui traversent l'embase 5.

Un dispositif de mesure 15 connecté à la tête 13 de mesure permet de mesurer la fréquence d'au moins une fonction résonante pendant l'attaque ionique. Ce dispositif de mesure peut être formé d'un ou plusieurs appareils de mesure tels que des vobulateurs avec recherche de maximum d'amplitude ou des analyseurs de réseaux fournissant l'évolution de l'amplitude en fonction de la fréquence.

Une tête de polarisation comparable à la tête de mesure est connectée à une source de polarisation 16 réglable.

Cette source de polarisation 16 peut être formée de plusieurs alimentations réglables, (une par électrode exposée au flux d'ions ou moins) ou d'une seule alimentation réglable comme sur la figure 2. Sur la figure 1a, la tête de polarisation et la tête de mesure sont confondues en une seule tête de mesure et de polarisation 13.

On polarise à l'aide de la source de polarisation 16 réglable au moins une électrode 4, 4' exposée au flux d'ions de manière à contrôler la vitesse d'attaque du métal de l'électrode 4, 4' par les ions. En polarisant l'électrode 4, 4' on modifie la vitesse d'attaque du métal par rapport à celle qu'elle serait sans polarisation. Cette polarisation permet de différencier cette électrode 4, 4' par rapport à l'autre ou aux autres électrodes de la même face qui sont soit non polarisées soit soumises à une autre tension de polarisation.

Un dispositif d'isolement 17 symbolisé par des capacités sur la figure 1a est prévu pour séparer la source de polarisation 16 du dispositif de mesure 15. Il est réalisé par tout dispositif connu en électronique.

Lorsque le nombre de fonctions résonantes à ajuster en fréquence est supérieur au nombre d'appareils de mesure de fréquence, on prévoit un premier dispositif de commutation 18 entre la tête de mesure et de polarisation 13 et le dispositif de mesure 15. Des commutations permettent de mesurer la fréquence de toutes les fonctions résonantes.

On peut aussi prévoir un second dispositif de commutation 19 entre la tête de mesure et de polarisation 13 et la source de polarisation 16 s'il y a plus d'électrodes à polariser que d'alimentation.

L'enceinte à vide 20 contient une atmosphère de gaz résiduelle, maintenue à un niveau spécifique ou régulée. Le gaz peut être de l'argon.

On se réfère maintenant à la figure 2.

Le dispositif piézoélectrique 1 a maintenant deux fonctions résonantes couplées mécaniquement. La lame 2 comporte sur une face deux électrodes 3, 3' distinctes (une par fonction résonante) et sur l'autre face une électrode 40 commune aux deux fonctions résonantes. Le reste du dispositif piézoélectrique est identique à celui représenté à la figure 1a. Les deux faces de la lame sont exposées au flux d'ions. L'attaque ionique du métal des électrodes 3, 3', 40 permet d'ajuster les fréquences des Fonctions résonantes et le couplage entre les deux fonctions résonantes. La source d'ions est formée de deux canons à ions 10 face à face. Les faisceaux 7 qu'ils produisent sont alignés sur l'axe XX'.

Que les fonctions résonantes soient couplées ou non, il n'est pas souhaitable de déséquilibrer la quantité de métal entre les deux électrodes 3, 40 d'une fonction résonante. Si le déséquilibre est trop important la fonction résonante risque d'avoir des résonances parasites.

Au lieu d'utiliser des diaphragmes qui coopèrent avec les canons 10, il est possible de focaliser le faisceau d'ions 7 grâce à une optique de focalisation 21. En sortie de l'optique 21 la section du faisceau d'ions 7 correspond à la surface à attaquer .

L'équipement selon l'invention est tout à fait automatisable. Plusieurs dispositifs piézoélectriques 1 à ajuster peuvent être disposés sur un système de chariotage se déplaçant suivant deux axes perpendiculaires dont un est sensiblement parallèle à l'axe XX'. Sur la figure 2 un système à barrette mobile 23 pouvant recevoir plusieurs dispositifs piézoélectriques 1 est représenté. Le système de chariotage peut être commandé automatiquement ou manuellement.

Avec un équipement tel que représenté sur la figure la une opération d'ajustage se déroulera par exemple de la manière suivante :

Un dispositif piézoélectrique 1 métallisé en excès avec deux fonctions résonantes, monté sur son embase 5 est placé en position d'ajustage. La tête de mesure et de polarisation 13 vient en contact avec les zones conductrices 22 et on mesure la fréquence de chaque fonction résonante. La tension d'accélération des ions est réglée à sa valeur nominale et l'attaque ionique commence. La fréquence des fonctions résonantes croît. Dès qu'une fonction résonante a atteint son objectif de fréquence, on applique une tension de polarisation à son électrode (4 par exemple) exposée aux ions.

La valeur de la tension de polarisation est en général égale ou supérieure à la tension d'accélération des ions. A partir de là, l'érosion de l'électrode 4 polarisée est stoppée tandis qu'elle continue sur l'électrode 4' non polarisée de l'autre fonction résonante. La fréquence de résonance de la fonction résonante pourvue de l'électrode 4 polarisée n'évolue plus.

Si le dispositif piézoélectrique 1 a plus de deux fonctions résonantes, on polarisera de la même façon l'électrode exposée de la fonction résonante suivante qui atteindra son objectif de fréquence.

Lorsque la dernière fonction résonante a atteint son objectif de fréquence, on peut annuler la tension d'accélération ou polariser la dernière électrode exposée de manière à stopper l'érosion sur toutes les électrodes.

Lorsque la tension de polarisation a une forte valeur, on soumet la lame 2 en matériau piézoélectrique à un fort champ électrique dirigé dans le sens de son épaisseur. Il y a un risque de claquage diélectrique dans la lame 2.

Pour l'éviter, on peut opérer de la manière suivante : le dispositif piézoélectrique 1 étant en place, on mesure les fréquences de toutes les fonctions résonantes et on les compare à leur objectif.

On applique une tension de polarisation sur une ou plusieurs électrodes exposées. Les tensions de polarisation sont choisies de telle sorte que toutes les fonctions résonantes atteignent leur objectif de fréquence dans le même temps d'exposition au flux d'ions.

Les valeurs des tensions sont choisies pour ralentir les vitesses d'érosion mais pas les annuler. Les écarts respectifs des tensions de polarisation entre électrodes sont fixés par les écarts respectifs entre la fréquence mesurée et la fréquence à atteindre. La variation de fréquence en fonction du temps d'exposition est sensiblement linéaire.

On applique la tension nominale d'accélération des ions. Les fonctions résonantes sont suivies en fréquence pendant l'ajustage. Les vitesses d'érosion des différentes électrodes sont différentes selon les tensions de polarisation appliquées. Il n'est pas nécessaire de polariser l'électrode de la fonction résonante la plus éloignée de son objectif de fréquence. Il est possible de corriger, si nécessaire en cours d'érosion les tensions de polarisation appliquées.

Lorsque toutes les fonctions résonantes ont atteint leur objectif de fréquence, la tension d'accélération est annulée .

Les tensions de polarisation sont relativement faibles par rapport à la tension d'accélération et la lame piézoélectrique n'est pas soumise à un champ électrique trop intense.

Avec le procédé selon l'invention, les objectifs de fréquence de toutes les fonctions résonantes peuvent être identiques ou différents et les fréquences de chacune avant l'ajustage peuvent être identiques ou différentes.

L'avantage de ce procédé tient à l'absence de mouvement mécanique mis en jeu pour différencier les fonctions résonantes face à l'ajustage. Le nombre d 'électrodes et de fonctions résonantes regroupées sur une même lame n'est pas limité. Il est possible de suivre en fréquence chaque fonction résonnante pendant toute l'opération d'ajustage. La définition des électrodes n'est pas modifiée après l'ajustage.

La figure 3 représente un dispositif piézoélectrique 1 à quatre fonctions résonantes découplées, placé face à la tête de mesure et de polarisation 13. Il y a sur la lame 2 piézoéelectrique quatre électrodes 31, 41 par face. La lame 2 est montée à plat sur une embase 5 céramique par collage. Huit plots de colle 30 assurent à la fois la fixation et les connexions électriques des huit électrodes 31,41.

Des zones conductrices 32 sont disposées sur l'embase 5 et sont reliées électriquement aux plots de colle 30. La tête de mesure et de polarisation 13 comporte huit pointes de test 14 montées élastiquement qui viennent en contact avec les huit zones conductrices 32 de l'embase 5.

## Revendications

**1 -** Procédé d'ajustage en fréquence d'un dispositif piézoélectrique (1) comportant au moins une fonction résonante formée de deux électrodes (4, 3) métallisées placées en vis à vis chacune sur une face différente d'une lame (2) en matériau piézoelectrique, caractérisé en ce qu'il consiste:
- à disposer la lame en matériau piézoélectrique, munie des électrodes métallisées en excès, en position d'ajustage à proximité d'au moins une source d'ions,
- à exposer la lame à un flux d'ions produit par la source, le flux d'ions attaquant le métal,
- à mesurer la fréquence de résonance de la fonction résonante pendant que la lame est en position d'ajustage,
- à porter au moins une électrode (4) exposée au flux d'ions à un potentiel de polarisation réglable de manière à contrôler la vitesse d'attaque du métal sur l'électrode (4).

**2 -** Procédé d'ajustage selon la revendication 1, caractérisé en ce qu'il consiste, lorsque la lame en matériau piézoelectrique comporte plusieurs fonctions résonantes, à régler le potentiel de polarisation appliqué sur une ou plusieurs électrodes (4,4') exposées au flux d'ions, à une valeur visant à annuler la vitesse d'attaque du métal sur les dites électrodes dès que les fonctions résonantes correspondant à ces électrodes ont atteint un objectif de fréquence déterminé.

**3 -** Procédé d'ajustage selon l'une des revendications 1 ou 2, caractérisé en ce qu'il consiste, lorsque la lame en matériau piézoélectrique comporte plusieurs fonctions résonantes, à régler le potentiel de polarisation appliqué sur une ou plusieurs électrodes exposées au flux d'ions, à une valeur choisie pour que les fonctions résonantes atteignent un objectif de fréquence déterminé en un même temps d'exposition au flux d'ions.

**4 -** Equipement d'ajustage er fréquence pour la mise en oeuvre du procédé selon l'une des revendications 1 à 3, caractérisé en ce qu'il comporte, dans une enceinte étanche (20), au moins un canon à ions (10) produisant un faisceau d'ions (7) dirigé selon un axe (XX') vers une face de la lame (2) en matériau piézoelectrique, des moyens (15) pour mesurer la fréquence de résonance de la fonction résonante, des moyens (16) pour appliquer le potentiel de polarisation réglable à l'électrode exposée au flux d'ions.

**5 -** Equipement d'ajustage en fréquence selon la revendication 4, caractérisé en ce que le faisceau d'ions (7) est limité par un diaphragme (12).

**6 -** Equipement d'ajustage en fréquence selon la revendication 4, caractérisé en ce que le faisceau d'ions (7) est focalisé par un objectif de focalisation (21)

**7 -** Equipement d'ajustage en fréquence selon l'une des revendications 4 à 6, caractérisé en ce que les moyens (15) pour mesurer la fréquence comportent un dispositif de mesure relié à une tête de mesure (13) venant en contact électrique avec les électrodes (3,3',4,4') de la lame en matériau piézoelectrique.

**8 -** Equipement d'ajustage en fréquence selon la revendication 7, caractérisé en ce que le dispositif de mesure (15) comporte un ou plusieurs appareils de mesure.

**9 -** Equipement d'ajustage en fréquence selon l'une des revendications 4 à 8, caractérisé en ce que les moyens (16) pour appliquer le potentiel comportent une source de potentiel réglable reliée à une tête de polarisation (13) venant en contact électrique avec les électrodes (3,3',4,4') de la la lame en matériau piézoélectrique.

**10 -** Equipement d'ajustage en fréquence selon la revendication 9, caractérisé en ce que la source de potentiel (16) est formée d'une ou plusieurs alimentations électriques réglables.

**11 -** Equipement d'ajustage en fréquence selon l'une des revendications 4 à 10, caractérisé en ce que la tête de mesure et la tête de polarisation sont confondues.

**12 -** Equipement d'ajustage en fréquence selon l'une des revendications 4 à 11, caractérisé en ce que le dispositif piézoélectrique (1) est supporté avec un ou plusieurs autres dispositifs piézoélectriques à ajuster par un dispositif de chariotage (23) mobile selon deux axes sensiblement perpendiculaires dont l'un est dirigé selon l'axe du faisceau d'ions (7).
